# EUROPÄISCHE PATENTSCHRIFT

(11) **EP 1 008 178 B1**
(45) Veröffentlichungstag und Bekanntmachung des Hinweises auf die Patenterteilung: **12.11.2003**
(21) Anmeldenummer: 98936132.4
(22) Anmeldetag: 09.06.1998
(51) Int. Cl.: H01L 21/8246

(54) **VERFAHREN ZUR HERSTELLUNG EINES NUR LESE-SPEICHERS**
METHOD OF PRODUCING A READ-ONLY MEMORY
PROCEDE DE PRODUCTION D'UNE MEMOIRE MORTE

(30) Priorität: 29.07.1997 DE 19732640
(43) Veröffentlichungstag der Anmeldung: 14.06.2000
(73) Patentinhaber: Infineon Technologies AG, 81669 München (DE)
(72) Erfinder: STEFFEN, Christian, D-81541 München (DE)
(74) Vertreter: Hermann, Uwe, Dipl.-Ing.
(86) Internationale Anmeldenummer: DE9801585
(87) Internationale Veröffentlichungsnummer: WO99007013

(56) Entgegenhaltungen:
- EP-A- 0 712 136
- US-A- 4 766 516

## Beschreibung

Die Erfindung betrifft ein Verfahren zur Herstellung eines Nur-Lese-Speichers.

Nur-Lese-Speicher werden auch als ROMs (Read Only Memories) bezeichnet. Es handelt sich dabei um nichtflüchtige, nicht löschbare Speicher. In der Praxis weit verbreitet ist das so-genannte Masken-ROM. Dabei wird der Nur-Lese-Speicher als integrierte Schaltung hergestellt, deren einzelne Schichten durch lithografische Projektionsverfahren hergestellt werden. Zur Durchführung eines lithographischen Projektionsverfahrens wird zunächst auf eine planare Schicht der integrierten Schaltung eine Resistschicht aufgetragen. Anschließend wird durch eine entsprechende Maske hindurch die gesamte Resistschicht an den von der Maske freigelassenen Stellen gleichzeitig belichtet. Nun wird die Maske entfernt und die Resistschicht entwickelt und ihre belichteten Partien werden entfernt. Die übrig bleibenden Partien der Resistschicht dienen anschließend einer weiteren Bearbeitung der integrierten Schaltung, beispielsweise einem Ätzprozeß oder einer Implantierung von Dotierstoffen.

Das geschilderte lithographische Projektionsverfahren ist das am häufigsten eingesetzte lithographische Verfahren zur Herstellung integrierter Schaltungen. Es erfordert wegen der ganzflächigen Belichtung (Projektion) der Resistschicht die Anfertigung der geschilderten Masken. Stehen die Masken jedoch einmal zur Verfügung, kann mit ihrer Hilfe in einem kurzen Zeitraum eine große Anzahl von identischen integrierten Schaltungen hergestellt werden.

Neben den geschilderten lithographischen Projektionsverfahren sind auch lithographische Strahlschreibverfahren bekannt, bei denen mittels eines Elektronenstrahls oder Ionenstrahls eine Belichtung einer Resistschicht vorgenommen wird. Ein solcher durch elektrische Felder steuerbarer Strahl ermöglicht die Herstellung sehr feiner Strukturen und macht die Anfertigung von Masken, wie sie für die lithographischen Projektionsverfahren notwendig sind, unnötig. Der Nachteil der Strahlschreibverfahren ist, daß die gewünschte Belichtung der Resistschicht einen wesentlich längeren Zeitaufwand erfordert als bei der ganzflächig durchgeführten Belichtung bei den Projektionsverfahren. Die lithographischen Strahlschreibverfahren werden daher nur zur Heerstellung sehr kleiner Strukturen innerhalb von integrierten Schaltungen, die mit geringen Stückzahlen hergestellt werden, eingesetzt.

Nur-Lese-Speicher, wie der im Dokument EP-A-0 712 136 offenbart, werden häufig in Chipkarten eingesetzt, wo sie als Speicher für einen ebenfalls in der Chipkarte angeordneten Prozessor dienen. Im ROM wird dann beispielsweise der vom Prozessor benötigte Microcode gespeichert. Bei vielen Anwendungen (beispielsweise wenn es sich um eine Kreditkarte handelt) ist es aus Sicherheitsgründen zusätzlich notwendig, in jeder Chipkarte eine individuelle Kennung (beispielsweise in Form der sogenannten PIN-Nummer) zu speichern. Da die übliche Maskenprogrammierung des ROMs ein Speichern individueller Daten je Chipkarte im ROM nicht zuläßt, wird die individuelle Kennung in einem EEPROM (Electrial Erasable Programable ROM) gespeichert, der zu diesem Zweck zusätzlich in der Chipkarte vorzusehen ist.

Ein EEPROM hat aufgrund seiner Löschbarkeit jedoch den Nachteil, daß eine Manipulation der darin gespeicherten, sicherheitsrelevanten Daten nicht ausgeschlossen werden kann.

Der Erfindung liegt die Aufgabe zugrunde, einen Speicher anzugeben, in dem sowohl ein erster Datensatz, der eine große Anzahl von Standarddaten enthält (beispielsweise den Microcode eines Prozessors), als auch ein zweiter Datensatz, der eine geringe Anzahl von individuellen Daten enthält (beispielsweise eine PIN-Nummer) gespeichert werden können.

Diese Aufgabe wird mit einem Herstellungsverfahen für einen solchen Nur-Lese-Speicher gemäß Anspruch 1 gelöst.

Die Erfindung sieht vor, den ersten Datensatz durch Bildung entsprechender erster Strukturen und den zweiten Datensatz durch Bildung entsprechender zweiter Strukturen innerhalb einer integrierten Schaltung eines gemeinsamen Nur-Lese-Speichers bzw. ROMs zu speichern. Dabei werden die ersten Strukturen durch ein lithographisches Projektionsverfahren unter Verwendung einer Maske hergestellt und die zweiten Strukturen durch ein lithographisches Strahlschreibverfahren ohne Verwendung einer Maske.

Der Einsatz des (für die Herstellung von ROMs üblichen) lithographischen Projektionsverfahrens ermöglicht eine schnelle und effektive Herstellung der für das Speichern des ersten Datensatzes herzustellenden ersten Strukturen. Beim ersten Datensatz handelt es sich daher um Daten, die in gleicher Weise in einer Vielzahl von herzustellenden ROMs zu speichern sind. Der erfindungsgemäße Einsatz des lithographischen Strahlschreibverfahrens ermöglicht es dagegen, daß die Daten des zweiten Datensatzes für jeden herzustellenden Nur-Lese-Speicher individuell verschieden sein können. Der zweite Datensatz kann beispielsweise, wenn der Nur-Lese-Speicher in einer Chipkarte eingesetzt wird, eine PIN-Nummer, eine Seriennummer oder ein für die Verschlüsselung (Kryptologie) von in der Chipkarte zu speichernden Daten notwendiger Schlüssel sein. In diesen Fällen enthält der zweite Datensatz nur eine geringe Anzahl von Daten, so daß die Herstellung der zweiten Strukturen trotz Verwendung eines lithographischen Strahlschreibverfahrens nur geringe Zeit in Anspruch nimmt.

Eine Weiterbildung der Erfindung sieht vor, daß die ersten und zweiten Strukturen durch Verwendung einer gemeinsamen Resistschicht hergestellt werden, die zur Erzeugung der ersten Strukturen unter Verwendung der Maske (Projektionsverfahren) und zur Erzeugung der zweiten Strukturen ohne Verwendung einer Maske (Strahlschreibverfahren) belichtet wird. Dieses Vorgehen bedingt, daß zur Herstellung der ersten und zweiten Strukturen insgesamt nur eine Resistschicht benötigt wird. Dies hat den Vorteil, daß die ersten und zweiten Strukturen in der gleichen Ebene der integrierten Schaltung in direkt aufeinanderfolgenden Herstellungsschritten erzeugt werden.

Eine Weiterbildung der Erfindung sieht vor, daß die durch das Projektionsverfahren und das Strahlschreibverfahren nacheinander belichtete Resistschicht strukturiert wird und daß die ersten und zweiten Strukturen durch Implantieren von Dotierstoffen unter Verwendung der strukturierten Resistschicht gebildet werden. Auf diese Weise kann in vorteilhafter Weise zum Speichern der beiden Datensätze beispielsweise die Dotierung von Kanälen von Feldeffekttransistoren eingestellt werden, wie anhand des Ausführungsbeispiels weiter unten noch erläutert wird.

Als lithographische Strahlschreibverfahren kommen insbesondere Elektronenstrahl- oder Ionenstrahlschreibverfahren in Betracht. Die Belichtung der Resistschicht kann jedoch auch mit einem Laserstrahlschreibverfahren erfolgen.

Die Erfindung wird im folgenden anhand eines Ausführungsbeispiels unter Zuhilfenahme der Figuren näher erläutert. Es zeigen:
- Figuren 1 bis 3: aufeinanderfolgende Schritte eines erfindungsgemäßen Herstellungsverfahren
- Figur 4: ein Prinzipschaltbild eines fertiggestellten Nur-Lese-Speichers.

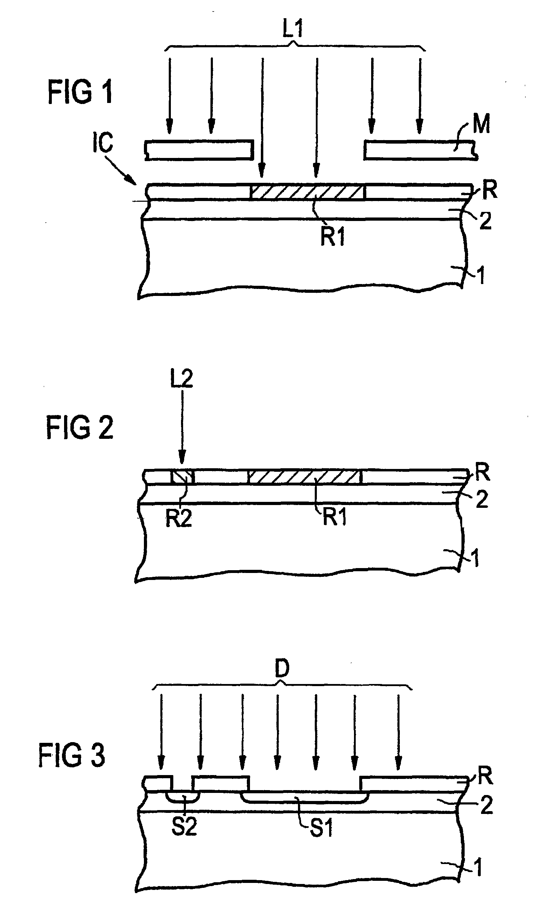

Figur 1 zeigt ein Siliziumsubstrat 1 mit einer darauf aufgebrachten Polysiliziumschicht 2 und einer wiederum darauf aufgebrachten Resistschicht R. Zur Herstellung des erfindungsgemäßen Nur-Lese-Speichers wird die Resistschicht R zunächst mittels eines lithographischen Projektionsverfahrens L1 unter Einsatz einer Maske M in Bereichen R1 belichtet. Anschließend wird die Maske M entfernt und gemäß Figur 2 erfolgt die Belichtung weiterer Bereiche R2 der Resistschicht R mittels eines lithographischen Strahlschreibverfahrens L2, in diesem Fall mit einem Elektronenstrahlschreibverfahren. Der Elektronenstrahl ist mittels eines elektrischen Feldes steuerbar.

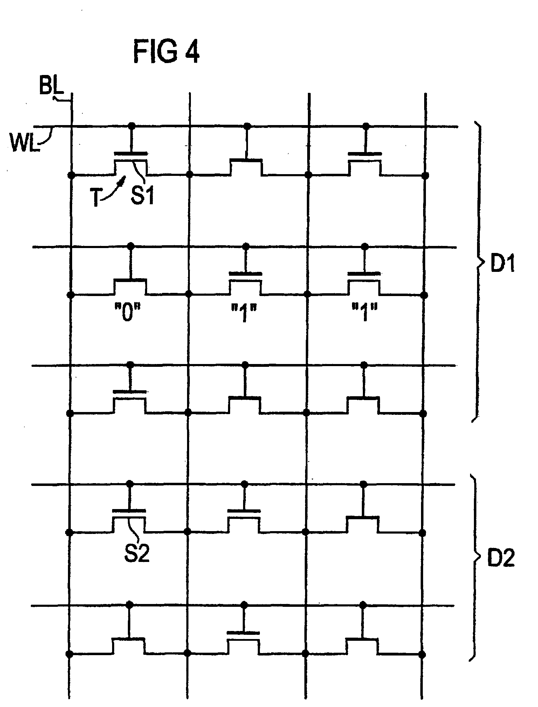

Gemäß Figur 3 werden die belichteten Partien R1, R2 der Resistschicht R entfernt und anschließend ein Dotierstoff D in die Polysiliziumschicht 2 implantiert. Auf diese Weise werden unterhalb der mit dem lithographischen Projektionsverfahren L1 belichteten Partien R1 der Resistschicht R erste Strukturen S1 und unterhalb der mit dem Strahlschreibverfahren L2 belichteten Partien R2 der Resistschicht R zweite Strukturen S2 in Form von dotierten Bereichen innerhalb der Polysiliziumschicht 2 hergestellt.

Figur 4 zeigt ausschnittsweise das Prinzipschaltbild eines Nur-Lese-Speichers, der mit einem erfindungsgemäßen Herstellungsverfahren gemäß den Figuren 1 bis 3 hergestellt worden ist. Er weist horizontal verlaufende Wortleitungen WL und vertikal verlaufende Bitleitungen BL auf. die Wortleitungen WL sind mit den Gates von Feldeffekttransistoren T verbunden. Source/Drain-Anschlüsse der Transistoren T sind mit je einer der Bitleitungen BL verbunden. In den Figuren 1 bis 3 wurde nur die Erzeugung der Strukturen S1, S2, die Kanalgebiete der Transistoren T in Figur 4 bilden, dargestellt. Die Herstellung der Wortleitungen WL, der Bitleitungen BL und der Source/Drain-Anschlüsse erfolgt auf bekannte Weise und wurde daher nicht dargestellt.

Die obersten drei Wortleitungen WL in Figur 4 dienen zum Speichern eines ersten Datensatzes D1, während die letzten beiden Wortleitungen zum Speichern eines zweiten Datensatzes D2 dienen.

Bei einigen der Transistoren T in Figur 4 ist kein Kanal zwischen den Source/Drain-Anschlüssen eingezeichnet. Bei diesen erfolgte weder durch das Projektionsverfahren L1 noch durch das Strahlschreibverfahren L2 eine Belichtung der Resistschicht R gemäß den Figuren 1 und 2. Daher wurden diese Kanalgebiete nicht (wie in Figur 3) gezeigt mit dem Dotierstoff D dotiert. Ein solcher nicht dotierter Kanal wird nicht leitfähig, selbst wenn das zugehörige Gate über die entsprechende Wortleitung WL aktiviert wird. Diese Transistoren T mit nicht dotierten Kanälen repräsentieren beim Ausführungsbeispiel gemäß Figur 4 innerhalb des ersten D1 und des zweiten D2 Datensatzes Daten vom Zustand "0".

Bei denjenigen Transistoren T in Figur 4, bei denen das Kanalgebiet gemäß Figur 3 dotiert worden ist, sind die entsprechenden Drain/Source-Anschlüsse über den als waagerechte Linie eingezeichneten Kanal miteinander verbunden. Diese Transistoren T repräsentieren den Zustand "1" innerhalb der beiden Datensätze D1, D2. Innerhalb des ersten Datensatzes D1 entsprechen die dotierten Kanäle den ersten Strukturen S1 aus Figur 3, während die dotierten Kanäle innerhalb des zweiten Datensatzes D2 den zweiten Strukturen S2 aus Figur 3 entsprechen.

Ein Auslesen des in Figur 4 dargestellten Nur-Lese-Speichers erfolgt durch Anlegen eines Potentials an eine der Bitleitungen des auszulesenden Transistors T und Aktivierung der mit seinem Gate verbundenen Wortleitungen WL. Durch Beobachtung des Potentials an der zweiten mit demselben Transistor T verbundenen Bitleitung BL kann erkannt werden, ob der Transistor leitet oder nicht, also ob er ein dotiertes Kanalgebiet aufweist oder nicht und somit eine logische "1" oder eine logische "0" gespeichert hat.

Da die ersten Strukturen S1 des ersten Datensatzes D1 mit einem lithographischen Projektionsverfahren L1 erzeugt werden, das den Einsatz einer Maske M notwendig macht (Figur 1), handelt es sich beim Datensatz D1 um solche Daten, die in einer Vielzahl von herzustellenden Nur-Lese-Speichern zu speichern sind. Beim Datensatz D1 kann es sich daher beispielsweise um von einem Prozessor benötigte Daten, wie beispielsweise seinen Microcode oder von ihm benötigte Tabellen handeln. Beim zweiten Datensatz D2 ermöglicht der erfindungsgemäße Einsatz eines lithographischen Strahlschreibverfahrens L2 (Figur 2), daß er für jeden herzustellenden Nur-Lese-Speicher unterschiedliche Daten aufweist. Da zur Erzeugung der zweiten Strukturen S2 keine Maske notwendig ist, kann der für die Lithographie verwendete Elektronenstrahl jeweils individuell gesteuert werden.

Die Erfindung weist den Vorteil auf, daß zur Speicherung eines zweiten Datensatzes D2 mit individuell für jeden herzustellenden Speicher verschiedenen Daten kein EEPROM vorgesehen werden muß, sondern daß hierfür ein ohnehin zum Speichern eines ersten Datensatzes D1 notwendiger Nur-Lese-Speicher verwendet werden kann. Durch Vermeiden des Einsatzes eines EEPROMs zum Speichern der für jeden Nur-Lese-Speicher individuell verschiedenen Daten des Datensatzes D2 entfällt auch die Manipulierbarkeit solcher Daten, da die zweiten Strukturen S2 nur innerhalb des Herstellprozesses des Nur-Lese-Speichers erzeugbar sind und, anders als bei EEPROMs, nicht gelöscht werden können.

Durch Verwendung einer gemeinsamen Resistschicht für das lithographische Projektionsverfahren L1 und das lithographische Strahlschreibverfahren L2 und die Erzeugung gleichartiger Strukturen S1, S2 ist der Aufwand zur Herstellung des erfindungsgemäßen Nur-Lese-Speichers nur geringfügig gegenüber der Herstellung eines reinen Masken-ROMs erhöht.

Da in der Regel oberhalb der in den Figuren 1 bis 3 gezeigten Schichten der integrierten Schaltung IC viele weitere Schichten aufgebracht werden, ist auch ein unbefugtes Auslesen des Nur-Lese-Speichers sehr erschwert. Um die Strukturen S1 und S2 zum Zweck des Lesens der beiden Datensätze D1, D2 zu analysieren, müssen nämlich die darüberliegenden Schichten der integrierten Schaltung IC entfernt werden, so daß der Nur-Lese-Speicher anschließend zerstört ist. Die Kenntnis des Inhalts des für den Nur-Lese-Speicher charakteristischen, individuellen zweiten Datensatzes D2 ist dann wertlos, da die integrierte Schaltung anschließend nicht mehr betrieben werden kann. Beim zweiten Datensatz D2 kann es sich daher um sicherheitsrelevante Daten wie beispielsweise um eine PIN-Nummer, eine Seriennummer des Nur-Lese-Speichers oder einen Code-Schlüssel zum Ver- oder Entschlüsseln von Daten handeln. Insbesondere PIN-Nummern und Code-Schlüssel kommen regelmäßig bei Chipkarten zum Einsatz.

Da ein im Nur-Lese-Speicher in Form des zweiten Datensatzes D2 abgelegter Code-Schlüssel von außerhalb nicht lesbar ist, könnten zwei verschiedene Code-Schlüssel innerhalb des zweiten Datensatzes D2 gespeichert werden. Dabei ist einer öffentlich, das heißt von jedermann über die Wortleitungen WL und Bitleitungen BL aus Figur 4 auslesbar. Der andere Schlüssel ist dagegen nicht nach außerhalb der Chipkarte auslesbar. Dieser verborgene Schlüssel würde zum Beispiel mittels eines Zufallsgenerators erstellt und mit dem öffentlichen Schlüssel zusammen in einer streng vertraulichen Referenzliste an befugte Benutzer weitergegeben. Schlüsselverfahren mit einem öffentlichen und einem verborgenen Schlüsselteil sind heute weitestgehend als sicher anerkannt, zum Beispiel PGP (Pretty Good Privacy) mit einem 64Bit-Schlüssel. Ein solches Verfahren würde sich insbesondere als Sicherheitsmaßnahme bei Chipkarten-ICs eignen, beispielsweise bei Anwendungen wie Electronic-Cash-Banking-Cards, Patientenkarten für Krankenkassen oder elektronischen Ausweisen.

## Patentansprüche

1. Verfahren zur Herstellung eines Nur-Lese-Speichers in Form einer integrierten Schaltung (IC), bei dem ein erster (D1) Datensatz, der eine große Anzahl von Standarddaten enthalten kann, und ein zweiter (D2) Datensatz,
der eine Geringe Anzahl von Standarddaten enthalten kann in Form von entsprechenden ersten (S1) bzw. zweiten (S2) Strukturen der integrierten Schaltung (IC) gespeichert werden,
wobei die ersten Strukturen (S1) durch ein lithographisches Projektionsverfahren (L1) unter Verwendung einer Maske hergestellt werden (M), **dadurch gekennzeichnet dass**,
die zweiten Strukturen (S2) durch ein lithographisches Strahlschreibverfahren (L2) ohne Verwendung einer Maske
und mittels eines steuerbaren Strahls hergestellt werden.

2. Verfahren nach Anspruch 1,
bei dem die ersten (S1) und zweiten (S2) Strukturen durch Verwendung einer gemeinsamen Resistschicht (R) hergestellt werden, die zur Erzeugung der ersten Strukturen (S1) unter Verwendung der Maske (M) und zur Erzeugung der zweiten Strukturen (S2) ohne Verwendung einer Maske belichtet wird.

3. Verfahren nach Anspruch 2,
bei dem die belichtete Resistschicht (R) strukturiert wird und bei dem die ersten (S1) und zweiten (S2) Strukturen durch Implantieren von Dotierstoffen (D) unter Verwendung der strukturierten Resistschicht (R) gebildet werden.

4. Verfahren nach einem der vorstehenden Ansprüche,
bei dem als lithographisches Strahlschreibverfahren (L2) ein Elektronenstrahl-, Ionenstrahl- oder Laserstrahlschreibverfahren verwendet wird.

## Claims

1. Method for the fabrication of a read-only memory in the form of an integrated circuit (IC), in which a first (D1) data record, which can contain a large number of standard data, and a second (D2) data record, which can contain a small number of standard data, are stored in the form of corresponding first (S1) and second (S2) structures, respectively, of the integrated circuit (IC),
wherein the first structures (S1) are fabricated by means of a lithographic projection method (L1) with the use of a mask (M), **characterized in that** the second structures (S2) are fabricated by means of a lithographic beam writing method (L2) without the use of a mask and by means of a controllable beam.

2. Method according to Claim 1,
in which the first (S1) and second (S2) structures are fabricated by using a common resist layer (R), which is exposed with the use of the mask (M) in order to produce the first structures (S1) and without the use of a mask in order to produce the second structures (S2).

3. Method according to Claim 2,
in which the exposed resist layer (R) is patterned, and in which the first (S1) and second (S2) structures are formed by the implantation of dopants (D) with the use of the patterned resist layer (R).

4. Method according to one of the preceding claims,
in which an electron beam, ion beam or laser beam writing method is used as the lithographic beam writing method (L2).

## Revendications

1. Procédé de production d'une mémoire morte sous la forme d'un circuit (IC) intégré, dans lequel un premier (D1) jeu de données, qui peut contenir un grand nombre de données standards, et un deuxième (D2) jeu de données, qui peut contenir un petit nombre de données standards, sont mémorisés sous la forme de premières (S1) et de deuxièmes (S2) structures correspondantes du circuit (IC) imprimé,
les premières structures (S1) étant produites par un procédé (L1) lithographique de projection en utilisant un masque (M), **caractérisé en ce que** les deuxièmes structures (S2) sont produites par un procédé (L2) lithographique d'écriture à faisceau sans l'utilisation d'un masque et au moyen d'un faisceau pouvant être réglé.

2. Procédé suivant la revendication 1,
dans lequel on produit les premières (S1) et deuxièmes (S2) structures en utilisant une couche (R) commune de réserve qui est exposée pour produire les premières structures (S1) en utilisant le masque (M) et pour produire les deuxièmes structures (S2) sans utiliser de masque.

3. Procédé suivant la revendication 2,
dans lequel on structure la couche (R) de réserve qui est exposée et dans lequel on forme les premières (S1) et les deuxièmes (2) structures par implantation de substances (D) de dopage en utilisant la couche (R) de réserve structurée.

4. Procédé suivant l'une des revendications précédentes ;
dans lequel on utilise comme procédé (L2) lithographique d'écriture par faisceau un procédé d'écriture par faisceau électronique, par faisceau ionique ou par faisceau laser.
